# EUROPEAN PATENT APPLICATION

(11) **EP 2 408 022 A1**
(43) Date of publication of application: **18.01.2012**
(21) Application number: 10169887.6
(22) Date of filing: 16.07.2010
(51) Int. Cl.: H01L 31/18, H01L 31/0224, H01L 31/0236

(54) **Thin Film Solar Cell Fabrication Process, Deposition method for TCO layer, and Solar cell precursor layer stack**

(71) Applicant: Applied Materials, Inc., Santa Clara, CA 95054 (US)
(72) Inventor: Schmidt, Ursula Ingeborg, 63755, Alzenau (DE); Sommer, Elisabeth, 63755, Alzenau (DE); Vermeir, Inge, 91077, Neunkirchen (DE); Kress, Markus, 63165, Mühlheim (DE); Kuhr, Niels, 63739, Aschaffenburg (DE); Obermeyer, Philipp, 63741, Aschaffenburg (DE); Severin, Daniel, 63477, Maintal (DE); Supritz, Anton, 93326, Offenstetten (DE)
(74) Representative: Zimmermann & Partner

(57) **Abstract**

Methods for manufacturing a layer stack for a thin-film solar cell and layer stacks are provided. The layer stack includes a transparent substrate (102) having a first refraction index, a transparent conductive oxide (TCO) layer (414) comprising ZnO, wherein the transparent conductive oxide layer (414) is deposited over the substrate (102) and has a second refraction index, and a further layer (413), which is deposited between the transparent conductive oxide layer (414) and the substrate (102), wherein the layer (413) has a third refraction index in a range from the first refraction index to the second refraction index, the layer comprises a metal, and wherein the layer composition has a metal content of 0.5 to 10 weight-%.
The metal influences the nucleation of the subsequently deposited TCO layer (414). Thereby, the surface texture of the TCO layer (414) after etching is influenced so that the desired structure of the textured TCO layer (414) can be obtained within a stable process window over the entire area of the substrate (102).

## Description

### BACKGROUND OF THE INVENTION

### Field of the Invention

Embodiments of the present invention generally relate depositing TCO layers and texturing TCO layers, which are deposited on a conditioned substrate, particularly for a front contact of solar cells. Specifically, they relate to a layer stack for a thin-film solar cell and a method of manufacturing a TCO layer of a thin-film solar cell.

### Description of the Related Art

Crystalline silicon solar cells and thin-film solar cells are two types of solar cells. Crystalline silicon solar cells typically use either monocrystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-n junctions. Suitable substrates include glass, metal, and polymer substrates.

To expand the economic uses of solar cells, efficiency must be improved. Solar cell stabilized efficiency relates to the proportion of incident radiation converted into usable electricity. For solar cells to be useful for more applications, solar cell efficiency must be improved beyond the current best performance of approximately 10% for Si based thin-film solar modules. With energy costs rising, there is a need for improved thin-film solar cells and methods and apparatuses for forming the same in a factory environment.

In order to improve the efficiency of a solar cell, light trapping is one aspect that can be improved. In order to improve trapping of the photons surface texture at the light entering side can be utilized.

Another aspect for improving mass production of solar cells is the use of large scale processes and improving the reliability at which processes can be conducted. Thus, there is a desire to improve the processes for increasing the efficiency on a large scale and for applications during industrial manufacturing.

### SUMMARY OF THE INVENTION

In light of the above, a layer stack for a thin-film solar cell according to independent claim 1 and a method of manufacturing a TCO layer of a thin-film solar cell according to independent claim 12 are provided.

Embodiments of the invention provide methods of depositing TCO layers and texturing TCO layers, which are deposited over a conditioned surface. According to one embodiment, a layer stack for a thin-film solar cell is provided. The layer stack includes a transparent substrate having a first refraction index, a transparent conductive oxide layer includes ZnO, wherein the transparent conductive oxide layer is deposited over the substrate and has a second refraction index, and a further layer, which is deposited between the transparent conductive oxide layer and the substrate, wherein the layer has a third refraction index in a range from the first refraction index to the second refraction index, the layer includes a metal, and wherein the layer composition has a metal content of 0.5 to 10 weight-%.

According to another embodiment, a method of manufacturing a TCO layer of a thin-film solar cell is provided. The method includes providing a transparent substrate, reactively sputtering a first layer from a target including at least 1 weight-% of a metal, DC sputtering a ZnO-containing transparent conductive oxide layer over the substrate, and texturing the ZnO-containing transparent conductive oxide layer.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.

Figure 1 is a schematic side-view of a tandem-junction thin-film solar cell according to one embodiment of the invention;

Figures 2 and 3 are schematic side-views of a front side of a semiconductor precursor illustrating light trapping, which can for example be utilized for a solar cell.

Figures 4A to 4E illustrate the layers deposited on a substrate according to embodiments described herein;

Figure 5 is a schematic flow chart of a method of depositing a TCO over a substrate according to embodiments described herein; and

Figure 6 is a schematic side-view illustrating an apparatus for depositing a layer stack according to embodiments described herein and for conducting a method according to embodiments described herein.

To facilitate understanding, identical reference numerals have been used, where possible, to designate identical or similar elements that are common to the figures. It is contemplated that elements and features of one embodiment may be beneficially incorporated into other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The term "substrate" as used herein shall embrace both inflexible substrates, e.g. a wafer or a glass plate, and flexible substrates such as webs and foils.

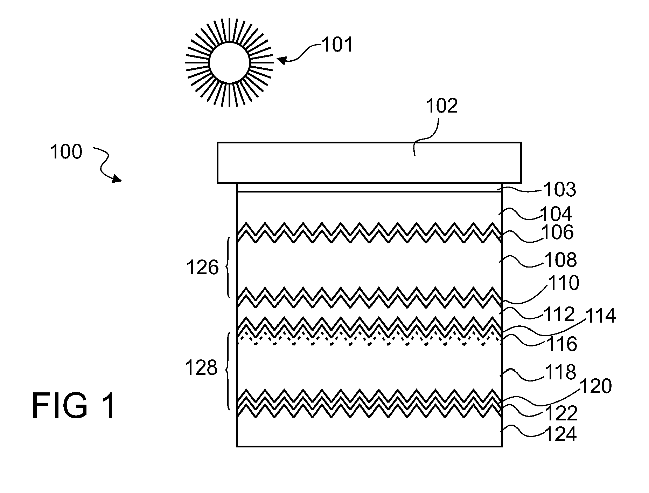

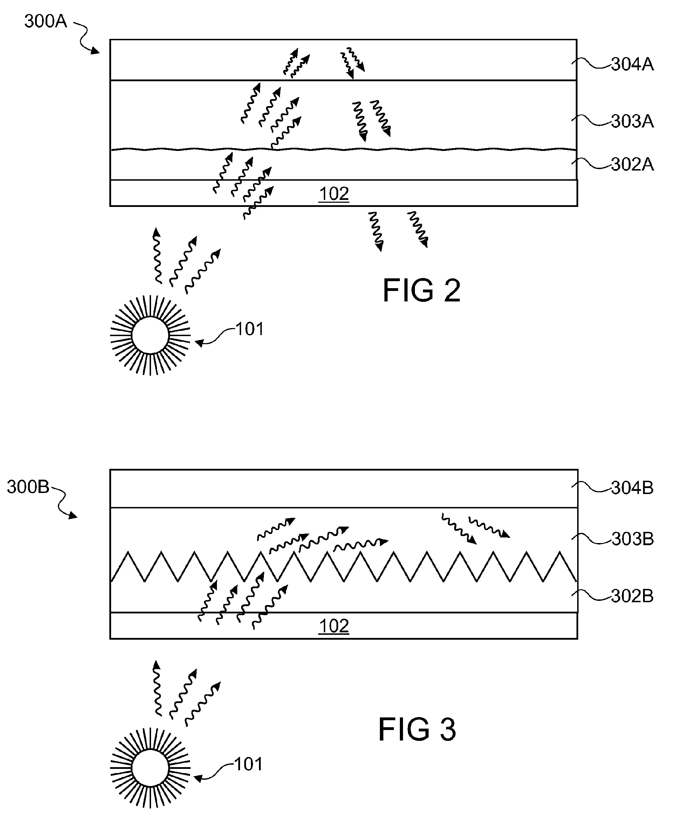

Embodiments described herein relate to processes for the etching of substrate precursors, a method for forming solar cells including etching of substrate precursors, devices for etching substrate precursors, and layer stacks for solar cells being based on substrate precursors with etching processes as described herein. Thereby, reference is for example made to the solar cells as described below and explained in further detail with respect to Figs. 1 and 2.

Thin-film solar cells are generally formed from numerous types of films, or layers, combined in many different ways. Most films used in such devices incorporate a semiconductor element that may include silicon, germanium, carbon, boron, phosphorous, nitrogen, oxygen, hydrogen and the like. Characteristics of the different films include degree of crystallinity, dopant type, dopant concentration, film refractive index, film extinction coefficient, film transparency, film absorption, and conductivity. Typically, most of these films can be formed by use of a chemical vapor deposition process, which may include some degree of ionization, plasma formation and/or sputtering processes.

Sputtering is a process in which atoms are ejected from a solid target material due to bombardment of the target by energetic particles. The process of coating a substrate as a material at the scraping refers typically to thin-film applications. The term "coating" and the term "depositing" are used synonymously herein. The terms "sputtering installation" and "deposition apparatus" are used synonymously herein and shall embrace for example an apparatus which uses sputtering for depositing a target material, typically as a thin film, on a substrate. Typical target materials include (but are not limited to) pure metals such as aluminum (Al), copper (Cu), silver (Ag) and gold (Au), metal alloys such as an aluminum-niobium (AlNb) alloy or an aluminum-nickel (AlNi) alloy, semiconductor materials such as silicon (Si) and dielectric materials such as nitrides, carbides, titanates, silicates, aluminates and oxides, e.g. transparent conducting oxides (TCO) such as impurity-doped ZnO, In₂O₃, SnO₂ and CdO, as well as Sn doped In₂O₃ (ITO) and F doped SnO₂.

According to different embodiments, a plurality of films can be used in solar cells. Charge generation during a photovoltaic process is generally provided by a bulk semiconductor layer, such as a silicon-containing layer. The bulk layer is also sometimes called an intrinsic layer to distinguish it from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon" may refer to any form of silicon having a crystal phase, including microcrystalline and nanocrystalline silicon.

FIG. 1 is a schematic diagram of an embodiment of a multi-junction solar cell 100 oriented toward the light or solar radiation 101. Solar cell 100 includes a substrate 102, such as a glass substrate, polymer substrate, metal substrate, or other suitable substrate, with thin films formed thereover. The solar cell 100 further includes a first transparent conducting oxide (TCO) layer 104 formed over the substrate 102, and a first p-i-n junction 126 formed over the first TCO layer 104. In one configuration, a wavelength selective reflector (WSR) layer 112 is formed over the first p-i-n junction 126. A second p-i-n junction 128 is formed over the first p-i-n junction 126, a second TCO layer 122 is formed over the second p-i-n junction 128, and a metal back layer 124 is formed over the second TCO layer 122. In one embodiment, a WSR layer 112 is disposed between the first p-i-n junction 126 and the second p-i-n junction 128, and is configured to have film properties that improve light scattering and current generation in the formed solar cell 100. Additionally, the WSR layer 112 also provides a good p-n tunnel junction that has a high electrical conductivity and a tailored bandgap range that affects its transmissive and reflective properties to improve the formed solar cell's light conversion efficiency.

To improve light absorption by enhancing light trapping, the substrate and/or one or more of the thin films formed thereover may be optionally textured by wet, plasma, ion etching, and/or mechanical processes. For example, in the embodiment shown in FIG. 1, the first TCO layer 104 is textured and the subsequent thin films deposited thereover will generally follow the topography of the surface below it.

According to some embodiments described herein, a further layer such as a buffer layer 103 is deposited between the substrate 102 and the TCO layer 104. Thereby, typically, the further layer can be a SiON-containing layer. The further layer is provided in order to have an improved nucleation of the transparent conductive oxide (TCO) layer, such as a ZnO-containing TCO layer. Accordingly, the substrate including, e.g., a buffer layer is conditioned for improved ZnO growth. According to embodiments described herein, the further layer includes a metal such as Al, Ti, Zn, or the like. Thereby, nucleation of the TCO layer can be influenced to provide for improved texturing and desired electrical and optical properties of the TCO layer. According to some embodiments, the conditioning can be conducted by depositing or preparing a metal-containing layer 103, e.g. that the layer is doped with a metal.

The first TCO layer 104 and the second TCO layer 122 may each include tin oxide, zinc oxide, indium tin oxide, cadmium stannate, combinations thereof, or other suitable materials. It is understood that the TCO materials may also include additional dopants and components. For example, zinc oxide may further include dopants such as aluminum, gallium, boron, and other suitable dopants. Zinc oxide preferably includes 5 atomic % or less of dopants, and more preferably includes 2.5 atomic % or less aluminum. In certain instances, the substrate 102 may be provided by the glass manufacturers with the first TCO layer 104 already provided.

The first p-i-n junction 126 may include a p-type amorphous silicon layer 106, an intrinsic-type amorphous silicon layer 108 formed over the p-type amorphous silicon layer 106, and an n-type microcrystalline silicon layer 110 formed over the intrinsic-type amorphous silicon layer 108. In certain embodiments, the p-type amorphous silicon layer 106 may be formed to a thickness between about 60Å and about 300Å. In certain embodiments, the intrinsic-type amorphous silicon layer 108 may be formed to a thickness between about 1,500Å and about 3,500Å. In certain embodiments, the n-type microcrystalline semiconductor layer 110 may be formed to a thickness between about 100Å and about 400Å.

The WSR layer 112 disposed between the first p-i-n junction 126 and the second p-i-n junction 128 is generally configured to have certain desired film properties. In this configuration the WSR layer 112 actively serves as an intermediate reflector having a desired refractive index, or ranges of refractive indexes, to reflect light received from the light incident side of the solar cell 100. The WSR layer 112 also serves as a junction layer that boosts the absorption of the short to mid wavelengths of light (*e.g.*, 400 nm to 700 nm) in the first p-i-n junction 126 and improves short-circuit current, resulting in improved quantum and conversion efficiency. Further, the WSR layer 112 has high film transmittance for mid to long wavelengths of light (*e.g.*, 500nm to 1100nm) to facilitate the transmission of light to the layers formed in the junction 128. Further, it is generally desirable for the WSR layer 112 to absorb as little light as possible while reflecting desirable wavelengths of light (*e.g.*, shorter wavelengths) back to the layers in the first p-i-n junction 126 and transmitting desirable wavelengths of light (*e.g.*, longer wavelengths) to the layers in the second p-i-n junction 128.

In one embodiment, the WSR layer 112 may include an n-type doped silicon alloy layer, such as silicon oxide (SiOₓ, SiO₂), silicon carbide (SiC), silicon oxynitride (SiON), silicon nitride (SiN), silicon carbon nitride (SiCN), silicon oxycarbide (SiOC), silicon oxycarbon nitride (SiOCN), or the like. In an exemplary embodiment, the WSR layer 112 is an n-type SiON or SiC layer.

The second p-i-n junction 128 may include a p-type microcrystalline silicon layer 114 and, in some cases, an optional p-i buffer-type intrinsic amorphous silicon (PIB) layer 116 that is formed over the p-type microcrystalline silicon layer 114. Subsequently, an intrinsic-type microcrystalline silicon layer 118 is formed over the p-type microcrystalline silicon layer 114, and an n-type amorphous silicon layer 120 is formed over the intrinsic type microcrystalline silicon layer 118. In certain embodiments, the p-type microcrystalline silicon layer 114 may be formed to a thickness between about 100Å and about 400Å. In certain embodiments, the p-i buffer-type intrinsic amorphous silicon (PIB) layer 116 may be formed to a thickness between about 50 Å and about 500 Å. In certain embodiments, the intrinsic-type microcrystalline silicon layer 118 may be formed to a thickness between about 10,000Å and about 20,000Å. In certain embodiments, the n-type amorphous silicon layer 120 may be formed to a thickness between about 100Å and about 500Å.

The metal back layer 124 may include, but is not limited to a material selected from the group consisting of Al, Ag, Ti, Cr, Au, Cu, Pt, alloys thereof, or combinations thereof. Other processes may be performed to form the solar cell 100, such as laser scribing processes. Other films, materials, substrates, and/or packaging may be provided over the metal back layer 124 to complete the solar cell device. The formed solar cells may be interconnected to form modules, which in turn can be connected to form arrays.

Solar radiation 101 is primarily absorbed by the intrinsic layers 108, 118 of the p-i-n junctions 126, 128 and is converted to electron-hole pairs. The electric field created between the p-type layer 106, 114 and the n-type layer 110, 120 that stretches across the intrinsic layer 108, 118 causes electrons to flow toward the n-type layers 110, 120 and holes to flow toward the p-type layers 106, 114 creating a current. According to some embodiments, which can be combined with other embodiments described herein, the first p-i-n junction 126 includes an intrinsic type amorphous silicon layer 108 and the second p-i-n junction 128 includes an intrinsic type microcrystalline silicon layer 118 since amorphous silicon and microcrystalline silicon absorb different wavelengths of the solar radiation 101. Therefore, the formed solar cell 100 is more efficient, since it captures a larger portion of the solar radiation spectrum. The intrinsic layer 108, 118 of amorphous silicon and the intrinsic layer of microcrystalline silicon are stacked in such a way that solar radiation 101 first strikes the intrinsic type amorphous silicon layer 118 and is transmitted through the WSR layer 112 and then strikes the intrinsic type microcrystalline silicon layer 118 since amorphous silicon has a larger bandgap than microcrystalline silicon. Solar radiation not absorbed by the first p-i-n junction 126 continuously transmits through the WSR layer 112 and continues to the second p-i-n junction 128.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the p-type and n-type layers 106, 110, 114, 120 described above by including boron-containing or phosphorus-containing compounds in the reaction mixture. Suitable boron and phosphorus compounds generally include substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus hydrogen ratios will include hydrogen used as a carrier gas for dopants.

According to different embodiments, a plurality of methods and system/apparatus configurations for texturing a semiconductor precursor can be utilized in embodiments described herein. As described above, the layers, particularly the TCO layer 104 are generally textured in order to improve light trapping and, thus, the efficiency of a solar cell. In the following, it is exemplarily referred to etching of zinc oxide (ZnO) layers as a front contact of precursors for a solar thin-film. However, the same principles can be applied to other semiconductor device manufacturing methods.

As illustrated with respect to FIGS. 2 and 3, texturing of layers or films in the semiconductor device can, for example, improve light trapping. FIGS. 2 and 3 show the semiconductor device precursor 300A and 300B, respectively. Layers 302A, 303A, 304A and 302B, 303B, 303C, respectively, are deposited above the substrate 102. As shown in FIG. 2, the layer 302 has a flat or almost flat upper surface. In light thereof, a portion of the radiation source 101, such as the sun for a solar cell device, can be reflected within the semiconductor device precursor. This is indicated by a portion of the photons being reflected at the upper surface of layer 304A in FIG. 2. Generally, the reflection increases the path length available for interaction of the photons for the desired light absorption. However, the photons can leave the layer stack for a solar cell after one reflection. Contrary thereto, as shown in FIG. 3, a textured surface 302B increases the likelihood of all, or at least 90 %, of the photons to enter the semiconductor device. Further, the photons are diffracted at the boundaries of the layers such that the photons might even remain in one layer by total internal reflection upon diffraction at the textured TCO layer. Thereby, the path length within the desired layer in which photons should be absorbed for light conversion is increased. This generally improves the efficiency of the layer stack for the solar cell.

According to embodiments described herein, an improved ZnO-containing TCO layer is deposited on an industrially-relevant scale. For example, the TCO layers of some embodiments described herein can be deposited on an area of 1.4 m² and above, 4 m² and above or 5 m² and above. Thereby, the surface on which the ZnO-containing TCO layer is to be deposited is conditioned to provide a desired nucleation area for the desired film properties.

According to typical embodiments described herein, a ZnO layer, which is used as a TCO, is texture-etched after deposition. Thereby, a good light scattering effect (haze) should be achieved.

High-haze ZnO films, which are deposited by RF sputter deposition, can be provided on small scales and to laboratory standards. However, the RF technique suffers from a very low deposition rate and the difficulty to scale up the process to large areas. Thereby, it is desired that the TCO layer has a high surface roughness with large lateral feature sizes in order to capture as much of the incoming sun light as possible in the Si absorber of the solar cell.

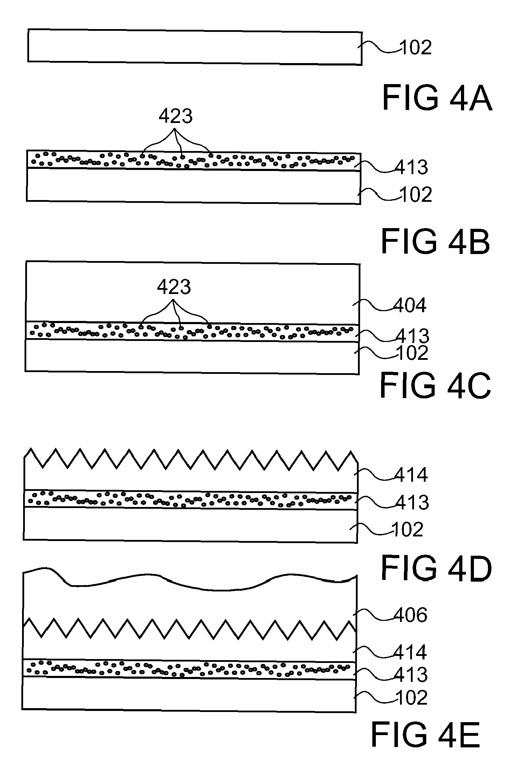

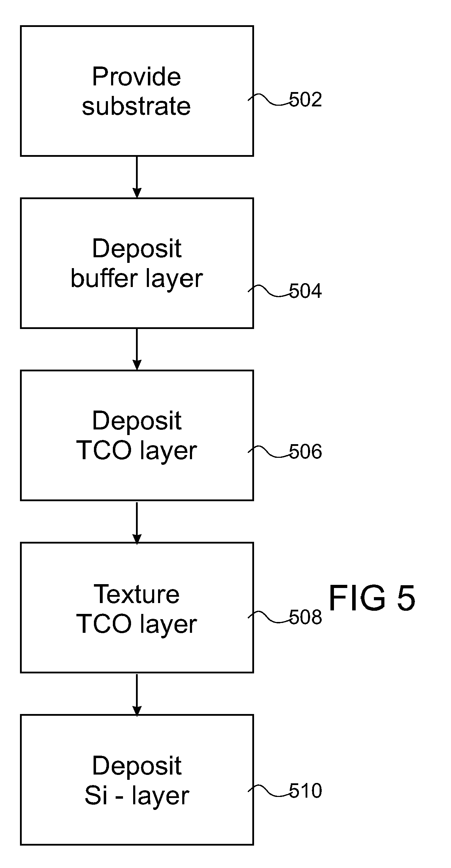

Typical embodiments are, for example, shown in FIGS. 4A to 4E and are described in the following while referring to the method illustrated in FIG. 5. FIG. 4A shows a substrate 102 which can be provided for depositing a precursor for a solar cell and/or TCO layer as shown in step 502. According to some embodiments, the TCO layer can be used as a front contact layer of a thin-film solar cell. In step 504, a layer 413, such as a buffer layer, is deposited on the substrate. This is illustrated by layer 413 shown in FIG. 4B. Thereby, according to some additional or alternative modification, the layer 413 can have a thickness of below 100 nm, for example a thickness of 20 nm to 100 nm or of 50 to 90 nm.

According to some embodiments, the layer can be referred to as a buffer layer. Thereby, it is indicated that a buffer for conditioning of the surface below, e.g., the surface of a substrate or the layer stack below, is provided, such that an improved nucleation of the subsequent layer can be provided. According to some embodiments, which can be combined with other embodiments described herein, the layer 413 can have a refraction index which is between the refraction indexes of the two neighboring layers, e.g. the refraction index of the transparent substrate 102 below layer 413 and the refraction index of the TCO layer 404. For example, the refraction index can be from 1.6 to 1.8.

According to yet further embodiments, which can be combined with other embodiments described herein, the layer 413 can be used as a barrier for diffusion of elements, e.g. a diffusion barrier for sodium (Na), which can be present in the substrate. For example, the layer can be a diffusion barrier which provides improved long term stability or an improved reliability. For example, the layer acting as a diffusion barrier can enable the layer stack to pass a delamination test such as the hot-tray test.

According to some embodiments, which can be combined with other embodiments described herein, the layer 413 can be a SiON layer, which is reactively sputtered from a silicon target with addition of oxygen and nitrogen. Thereby, a certain amount of metals such as aluminum, titanium or zinc can incorporated in the layer 413 by utilizing a mixed-target composition instead of pure silicon. This is indicated by incorporated elements 423 in Fig. 4B. Although the incorporated metal is drawn as small circles in the figure, it is understood that the metal can also be included homogeneously.

According to yet further embodiments, which can be combined with other embodiments described herein, the layers 103, 203, 413 and the like, which are used as a nucleation surface for the TCO layers 104, 204, and 404, respectively, can improve morphology, optical and electrical properties, which are optimized for a precursor of a solar cell. For example, the refraction index can be adjusted as described herein. Further, a barrier function, can be provided and/or the layer can have an average absorption of below 1% or even below 0.5% in the visible wavelength range or the visible wavelength range and the NIR wavelength range, e.g. from 300 to 1300 nm.

According to a typical embodiment, which can be combined with other embodiments described herein, a silicon target with an aluminum content, for example of 2 to 10 weight-%, can be used for depositing the layer 413. Yet, according to other embodiments, other metal additions in the silicon target such as Ti, Zn or combinations thereof might also be used.

Adding a metal such as aluminum to the layer 413, thereby, influences the surface texture of the subsequent TCO layer after etching. For example, the process window of different parameters of a desired structure, which have to be within predetermined values over the entire surface of a large are substrate, can be widened for the desired surface texture during the sputter process. According to embodiments described herein, the desired structure of a textured TCO layer can be obtained within a stable process window over the entire substrate when the metal-containing layer 413 is provided. According to yet further additional or alternative modifications, the metal-containing layer 413 can be a MF sputtered layer. According to yet further embodiments, which can be combined with other embodiments described herein, the middle frequency sputtering process with frequencies in the range of 5 kHz to 100 kHz, for example, 30 kHz to 50 kHz, can be provided for manufacturing a layer of the solar cell layer stack. As shown in FIG. 4C and step 506 of FIG. 5, a zinc oxide layer 404 (see FIG. 4C) is deposited onto the layer 413. Thereby, according to embodiments described herein, a DC sputtered TCO layer 404, e.g. a DC-sputtered ZnO-containing layer, can be provided. Further typical embodiments relate to aluminum doped zinc-oxide layers (ZnO:Al) as a TCO, which can be sputtered from rotatable ceramic zinc-oxide aluminum oxide (ZnO:Al2O3) targets. Typically, the aluminum-doped zinc-oxide layers form a front contact of a solar cell.

Typically, a doped ZnO layer is deposited by DC-sputtering process as a TCO front contact with a thickness of about 800 - 1000 nm. The dopant can be, but is not restricted to, aluminum. Finally, the layer stack is etched in diluted acid in order to roughen the ZnO surface by wet etching. In step 508, the TCO layer is textured resulting in the solar cell precursor shown in FIG. 4D. For example, the textured transparent conductive oxide layer can have a layer thickness of 400 nm to 700 nm, typically 400 nm to 600 nm, wherein the thickness of the texture surface is measured with X-ray fluorescence (XRF).

In light of the above, according to some embodiments, which can be combined with other embodiments described herein, a DC-sputtered and texture-etched ZnO TCO layer can be provided, wherein the ZnO layer is deposited over another layer, such as a SiON buffer layer. Thereby, according to some additional or alternative modification, the further layer can have a thickness of 100 nm or less. Yet further, the layer can be deposited on a washed glass substrate, e.g. by reactive sputtering.

It is commonly accepted that the deposition parameters of the ZnO layer such as the temperature or other parameters (e.g. pressure) have an impact on the surface morphology after etching and therefore on the efficiency of the solar module. Thereby, particularly for large area substrates as described herein, the deposition parameters might not be sufficiently uniform over the entire surface area in order to manufacture a sufficiently uniform textured TCO layer. In light of the embodiments described herein, it is possible to widen the windows of the deposition parameters for a sufficiently uniform deposition.

According to some embodiments, which can be combined with other embodiments described herein, the solar cell precursors, the layer stacks for solar cells and the methods and devices for manufacturing TCO layers can be utilized for large area thin-films. For example, substrate sizes of 1.43 m² (Gen5) and above such as 5.7 m² (Gen8.5) or larger can be realized. Further typical embodiments relate to aluminum-doped zinc-oxide layers (ZnO:Al) as a TCO, which can be sputtered from rotatable ceramic zinc-oxide aluminum-oxide (ZnO:Al2O3) targets. Typically, the aluminum-doped zinc-oxide layers form the front contact of a solar cell. According to yet further embodiments, the TCO layer can be wet-chemically etched, for example in diluted hydrochloric acid, or other suitable etchants. Thereby, as described above, the etching process is of importance for the surface texture, which is used to scatter the light, particularly the long wavelength light.

Typically, the shape and feature size of the etched layer depends on the parameters of the layer as well as the etching process. Accordingly, for a predetermined layer with certain characteristics, the nucleation of the layer to be etched needs to be controlled such that the desired texture of the layer is generated.

According to different embodiments, the texturing can be conducted by a wet etching process or a dry etching process. According to yet further implementations, the etching process can be an isotropic or an anisotropic etching process. Typically, the texturing step 508 can be provided by etching the zinc oxide-containing TCO layer with a diluted acid in order to roughen the ZnO surface by wet etching. Thereby, as described with respect to FIGS. 2 and 3, a specific haze is desired in order to improve light trapping of the layer stack for manufacturing a thin-film solar cell.

After texturing the TCO layer in step 508, a silicon layer 406 is deposited in step 510. According to typical embodiments, the silicon layer can be a p-type silicon layer, for example a p-type amorphous silicon layer 106 shown in FIG. 1. Alternatively, a p-type crystalline silicon layer 206 shown in FIG. 2 can be deposited on the textured TCO layer 414. Generally, one or more p-n-junctions are deposited on the TCO layer. Thereby, the textured TCO layer 414 forms the front contact of a precursor of a thin-film solar cell.

The inventors have found that the very first nucleation of the zinc oxide on the substrate is a key factor for the ongoing film growth and the finally obtained surface morphology after etching. In particular, the composition and structural information of the underlying buffer layer, which is deposited prior to the deposition of the zinc oxide, can increase the feature size of the etched ZnO surface to a huge extent. In addition, it is expected that the desired structure can be obtained within a stable process window over the entire substrate area

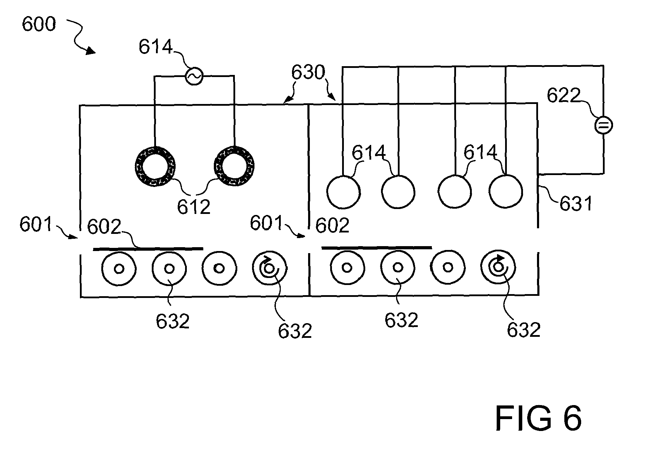

FIG. 6 illustrates an apparatus 600 for depositing a TCO layer according to embodiments described herein. The apparatus 600 includes two or more chambers 630 or respective compartments. A transport system with, for example, rollers 632 for transporting a substrate 602 through the system 600 is provided. Typically the chambers have openings 601 for introducing the substrate 602 in the chamber and transferring the substrate into a subsequent chamber or out of the chamber. According to typical embodiments, the openings 601 can be sealed with valves during operation of the system 600. As shown in FIG. 6, sputtering cathodes 612, such as rotatable sputtering cathodes, can be provided in the first chamber of the chambers 630. A power supply 614 provides power for the middle frequency sputtering process for depositing the layer 413 shown e.g. in FIG. 4B. According to some embodiments, which can be combined with other embodiments described herein, the middle frequency sputtering having frequencies in the range of 5 kHz to 100 kHz, for example, 30 kHz to 50 kHz, can be provided for manufacturing one or more layers of the solar cell layer stack. As indicated in Fig. 6, the target 613 includes a metal. For example, a metal-containing silicon target can be used. Typically, an aluminum-containing silicon target can be used, e.g. with a Al concentration of 2 to 10 weight-% for conducting a method of TCO deposition.

After the buffer layer has been deposited in the left (first) chamber of the system 600 shown in FIG. 6, the substrate is transferred in the second chamber 630. The second chamber includes sputtering cathodes 614, such as rotatable sputtering cathodes, for sputtering the TCO layer, such as a zinc oxide layer, on the substrate 602. Thereby, a TCO layer, which can be textured in the subsequent processing step such as a wet etching step, is deposited over the substrate.

As shown in Fig. 6, the TCO sputtering process is a DC sputtering process, wherein a power supply 622 provides a DC voltage between the cathodes 614 and, for example, the chamber wall 631. According to alternative embodiments the DC voltage might also be provided between the cathodes and separate anodes. According to yet further alternative or additional modifications, pulses might be added to the DC voltage, for example by a second power supply.

In light of the above, a plurality of embodiments has been described. According to one embodiment, a layer stack for a thin-film solar cell, is provided. The layer stack includes a transparent substrate having a first refraction index, a transparent conductive oxide layer including ZnO, the transparent conductive oxide layer is deposited over the substrate and has a second refraction index, and a further layer, which is deposited between the transparent conductive oxide layer and the substrate, wherein the layer has a third refraction index in a range from the first refraction index to the second refraction index, the layer includes a metal, and wherein the layer composition has a metal content of 0.5 to 10 weight-%. According to modifications thereof, the further layer can be a SiON-containing layer; the further layer can be a reactively sputtered layer, the metal in the further layer can be selected from the group consisting of: Al, Ti, Zn and mixtures thereof; the Si content in the SiON-containing layer can be about 30 weight-% or above, and/or the substrate can have an area of 1.4 m² or more, typically of 5 m² or more. According to yet further alternative or additional modifications, the transparent conductive oxide layer can incoude at least 90 weight-% ZnO, the transparent conductive oxide layer can be a DC sputtered layer, and/or the transparent conductive oxide layer can be a texture layer, particularly being textured by an etching process, for example a textured transparent conductive oxide layer with a layer thickness of 400 nm to 700 nm.

According to another embodiment a method of manufacturing a TCO layer of a thin-film solar cell can be provided. The method includes providing a transparent substrate, reactively sputtering a first layer from a target including at least 1 weight-% of a metal, DC sputtering a ZnO-containing transparent conductive oxide layer over the substrate, and texturing the ZnO-containing transparent conductive oxide layer. According to typical modifications thereof the method can further include doping the transparent conductive oxide layer, the transparent conductive oxide layer can be deposited with a deposition rate adapted to deposited an 800 nm thick layer within 10 min or less, and/or the texturing can include etching the ZnO-containing transparent conductive oxide layer, particularly etching the ZnO-containing transparent conductive oxide layer with diluted acid.

Beside the better light scattering properties after etching, the improved nucleation of the ZnO can also lead to a higher conductivity and reduced absorption since the overall film quality is improved. Therefore, every application which requires a highly conductive and transparent TCO based on doped ZnO might benefit from the embodiments described herein.

Further, it is expected to get a significantly higher solar module current and therefore higher efficiencies with respect to the standard approach without a modified silicon target composition.

While the foregoing is directed to embodiments of the present invention, other and further embodiments of the invention may be devised without departing from the basic scope thereof, and the scope thereof is determined by the claims that follow.

## Claims

1. A layer stack for a thin-film solar cell, comprising:
a transparent substrate having a first refraction index;
a transparent conductive oxide layer comprising ZnO, the transparent conductive oxide layer is deposited over the substrate and has a second refraction index; and
a further layer, which is deposited between the transparent conductive oxide layer and the substrate, wherein the layer has a third refraction index in a range from the first refraction index to the second refraction index, the layer comprises a metal, and wherein the layer composition has a metal content of 0.5 to 10 weight-%.

2. The layer stack according to claim 1, wherein the further layer is a SiON-containing layer.

3. The layer stack according to any of claims 1 to 2, wherein the further layer is a reactively sputtered layer.

4. The layer stack according to any of claims 1 to 3, wherein the metal in the further layer is selected from the group consisting of: Al, Ti, Zn and mixtures thereof.

5. The layer stack according to any of claims 2 to 4 wherein the Si content in the SiON-containing layer is about 30 weight-% or above.

6. The layer stack according to any of claims 1 or 5, wherein the transparent conductive oxide layer comprises at least 90 weight-% ZnO.

7. The layer stack according to any of claims 1 or 6, wherein the transparent conductive oxide layer is a DC sputtered layer.

8. The layer stack according to any of claims 1 to 7, wherein the transparent conductive oxide layer is a texture layer, particularly being textured by an etching process.

9. The layer stack according to claim 8, wherein the textured transparent conductive oxide layer has a layer thickness of 400 nm to 700 nm.

10. The layer stack according to any of claims 1 to 9, wherein the substrate has an area of 1.4 m² or more, typically of 5 m² or more.

11. A method of manufacturing a TCO layer of a thin-film solar cell, the method comprising:
providing a transparent substrate;
reactively sputtering a first layer from a target comprising at least 1 weight-% of a metal;
DC sputtering a ZnO-containing transparent conductive oxide layer over the substrate; and
texturing the ZnO-containing transparent conductive oxide layer.

12. The method according to claim 11, further comprising:
doping the transparent conductive oxide layer.

13. The method according to any of claims 11 to 12, wherein the transparent conductive oxide layer is deposited with a deposition rate adapted to deposited an 800 nm thick layer within 10 min or less.

14. The method according to any of claims 11 to 13, wherein the texturing comprises:
etching the ZnO-containing transparent conductive oxide layer, particularly etching the ZnO-containing transparent conductive oxide layer with diluted acid.
